## Europäisches Patentamt

## European Patent Office

## Office européen des brevets

(19)

(11) Veröffentlichungsnummer: **0 003 733**
**B1**

(12) **EUROPÄISCHE PATENTSCHRIFT**

(45) Veröffentlichungstag der Patentschrift: **08.04.81**

(21) Anmeldenummer: **78101414.7**

(22) Anmeldetag: **20.11.78**

(51) Int. Cl.³: **H 01 L 21/312,**
**H 01 L 29/10, H 01 L 29/78**
**//H01L21/72**

(54) **Verfahren zur Erzeugung abgestufter Fenster in Materialschichten aus Isolations- bzw. Elektrodenmaterial für die Herstellung einer integrierten Halbleiterschaltung und nach diesem Verfahren hergestellter MIS-Feldeffekttransistor mit kurzer Kanallänge.**

(30) Priorität: **05.12.77 DE 2754066**

(43) Veröffentlichungstag der Anmeldung:
**05.09.79 Patentblatt 79/18**

(45) Bekanntmachung des Hinweises auf die Patenterteilung:
**08.04.81 Patentblatt 81/14**

(84) Benannte Vertragsstaaten:
**BE DE FR GB NL**

(56) Entgegenhaltungen:
**DE - A - 2 703 877**
**DE - A - 2 723 933**
**GB - A - 1 440 643**
**US - A - 3 490 943**

(73) Patentinhaber: **SIEMENS AKTIENGESELLSCHAFT**
**Berlin und München**
**Postfach 22 02 61**
**D-8000 München 22 (DE)**

(72) Erfinder: **Tihanyi, Jenö**
**Wolfratshauser Strasse 179b**
**D-8000 München 71 (DE)**
Erfinder: **Bell, Guido**
**Fürstenfelder Weg 4**
**D-8031 Gilching (DE)**

Courier Press, Leamington Spa, England.

## Verfahren zur Erzeugung abgestufter Fenster in Materialschichten aus Isolations- bzw. Elektrodenmaterial für die Herstellung einer integrierten Halbleiterschaltung und nach diesem Verfahren hergestellter MIS-Feldeffekttransistor mit kurzer Kanallänge.

Die Erfindung betrifft ein Verfahren zur Erzeugung abgestufter Fenster in Materials-chichten aus Isolations- bzw. Elektroden-material für die Herstellung einer integrierten Halbleiterschaltung, wobei auf einem Halbleiterkörper oder auf einer auf ihm befindlichen Schicht die Materialschichten übereinander aufgebracht und unter Verwendung von Lackmasken soweit weggeätzt werden, daß die dem Halbleiterkörper benachbarte untere Materialschicht unter dem Rand der obenliegenden Materialschicht hervorragt. Die Erfindung betrifft ferner einen nach diesem Verfahren hergestellten MIS-Feldeffekt-transistor mit kurzer Kanallänge. Ein Verfahren der eingangs genannten Art ist aus der GB - A - 1 440 643 zu entnehmen.

Bei MIS-Feldeffekttransistoren, z.B. Oberflächen-Feldeffekttransistoren mit MOS-Struktur, ist die Isolierschicht meist als ein unter dem Rand der Gate-Elektrode hervorstehendes Podest ausgebildet, um einen Kontakt der Gate-Elektrode mit dem Halbleitermaterial zu verhindern. Eine derartige stufenförmige Struktur kann z.B. dadurch hergestellt werden, daß das Isoliermaterial und das Elektrodenmaterial schichtweise auf die Halbleiteroberfläche aufgetragen und in diese Schichten die für die Schaltung nötigen Fenster eingeätzt werden. Hierbei werden zwei aufeinander genau einjustierte Lackmasken verwendet. Die dabei unvermeidliche Ungenauigkeit der Justierung bewirkt, daß die Breite der hervorstehenden Isolierschicht-Stufe nicht beliebig klein gewählt und nur mit einem relativ großen Toleranzbereich vorgegeben werden kann. Ferner ist die Verwendung zweier Lackmasken und deren sorgfältige Justierung verhältnismäßig aufwendig.

Der Erfindung leigt die Aufgabe zugrunde, die Herstellung einer integrierten Schaltung mit derartig abgestuften Schichten aus Isolations- und Elektrodenmaterial zu vereinfachen. Insbesondere soll die Stufenbereite, um die die untere Schicht hervorsteht, innerhalb enger Grenzen vorgegeben können, was die Herstellung eines Feldeffekttransistors mit sehr kurzer Kanallänge ermöglicht.

Dies wird dadurch erreicht, daß bei einem Verfahren der eingangs angegebenen Art nur eine einzige Lackmaske verwendet wird. Dabei wird nach dem Aufbringen der Materialschichten die Lackmaske auf die obenliegende Materialschicht aufgetragen, wobei die Maskenöffnungen der Lackmaske derart gewählt werden, daß sie über den in die untere Materialschicht zu ätzenden Fenstern liegen und etwas kleiner sind als diese Fenster. Anschließend wird die obere Materialschicht durch die Maskenöffnungen selektiv weggeätzt, wobei die Lackmaske um eine vorgebare Länge unterätzt wird. Sodann wird die Lackmaske, gegebenenfalls nach vorangehendem Aufquellen, über den Fließpunkt aufgeheizt, bis sie sich auf die durch die Unterätzung freigelegten Teilflächen der unteren Materialschicht auflegt. Schließlich werden die von der abgesenkten Lackmaske freigegebenen Flächen der unteren Materialschicht weggeätzt.

Als Isoliermaterial kann vorteilhaft Siliziumdioxid verwendet werden. Man kann aber auch $Al_2O_3$ oder $Si_3N_4$ verwenden. Als Elek-trodenmaterial ist insbesondere Polysilizium geeignet.

Zum Ätzen der unteren Schicht wird ein selektives Ätzverfahren, z.B. Naßätzen, verwendet.

Die abgestuften Schichten können vorteilhaft als Maske Für eine Ionenimplantation in den Halbleiterkörper verwendet werden. Dadurch lassen sich MIS-Feldeffekttransistoren mit besonders kurzer Kanallänge herstellen.

Der nach dem erfindungsgemäßen Verfahren hergestellte erfindungsgemäße MIS-Feldeffekt-transistor ist in Anspruch 6 gekennzeichnet.

Das Wesen der Erfindung wird anhand mehrerer Ausführungsbeispiele und Figuren noch näher erläutert.

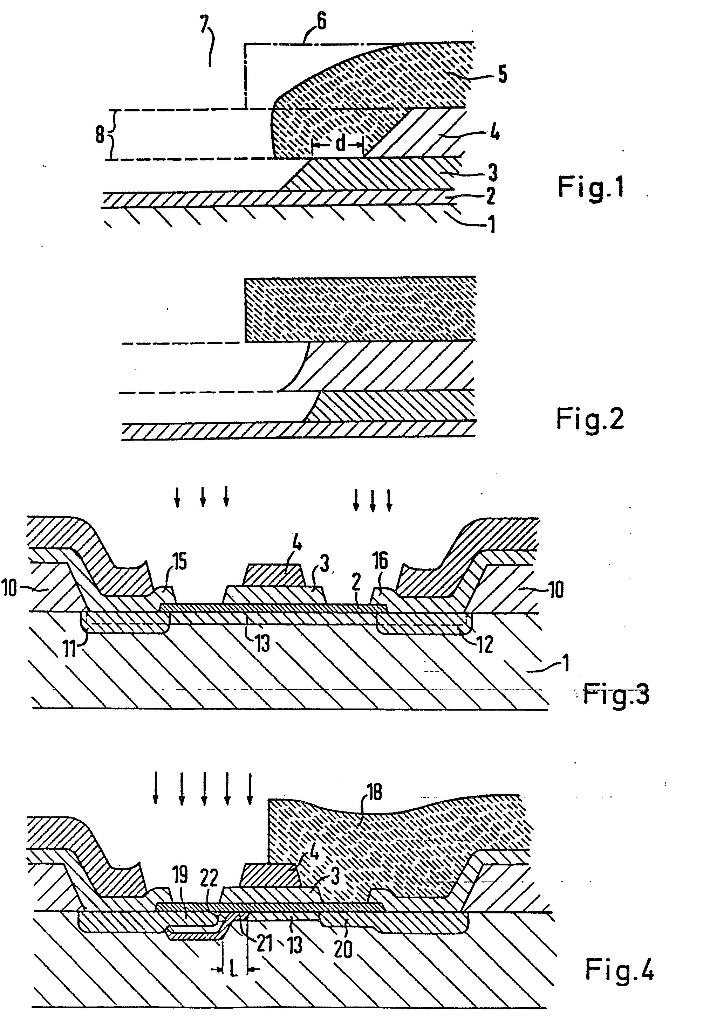

Fig. 1 zeigt einen Halbleiterkörper 1, dessen Oberfläche mit einer Dünnoxidschicht 2, einer Schicht 3 aus Elektrodenmaterial (Polysilizium) als untere Materialschicht und einer Dickoxidschicht 4 als obenliegende Materialschicht bedeckt ist. Als Oxidschicht kann z.B. $SiO_2$ oder $Al_2O_3$ verwendet werden, es ist aber auch $Si_3N_4$ geeignet. Die Schichten 2, 3 und 4 werden zunächst über die ganze Halbleiteroberfläche aufgebracht, wie durch die unterbrochenen Linien 8 angedeutet ist.

Über die oberste Materialschicht 4 wird eine Lackmaske mit einer Maskenöffnung 7 aufgebracht, deren Kontur in nicht absgesenktem Zustand durch die strichpunktierte Linie 6 angedeutet ist und die weiterhin als ursprüngliche Lackmaske 6 bezeichnet wird. Durch selektives Ätzen, z.B. ein Naßätzverfahren, wird nun die Materialschicht 4 unter der Maskenöffnung 7 weggeätzt. Die Materialschicht 4 wird dabei auch in einer vorgebbaren, definierten Breite unter der ursprünglichen Lackmaske 6 weggeätzt. Wurde als Lackmaske nicht-ausgeheizter Fotolack benutzt, so wird nun der Lack über den Fließpunkt aufgeheizt, so daß er sich nunmehr auf die freigelegten Flächen der unter Dickoxidschicht 4 liegenden Polysiliziumschicht 3 auflegt. Die Kanten der Dickoxidschicht 4 sind somit beim weiteren Fortgang des Verfahrens abgedeckt. Wird als Lackmaske ein ausgeheizter Lack verwendet, so wird der Lack vor dem Aufheizen aufgequollen.

Durch geeignete Maßnahmen, wie sie z.B. in der deutschen Offenlegungsschrift 25 54 638 oder der deutschen Offenlegungsschrift 27 23 933 beschrieben sind, kann dabei vorteilhaft erreicht werden, daß Ätzkanten einen definierten Böschungswinkel aufweisen. In dieser Literaturstelle sind auch geeignete Ätzverfahren, insbesondere die vorteilhafte Plasma-Ätzung, beschrieben.

Die beim selektiven Ätzen der Dickoxidschicht 4 nicht angegriffene Polysiliziumschicht 3 kann nun geätzt werden, wobei wiederum definierte Böschungswinkel erreichbar sind. Bei dieser Ätzung entsteht in der Polysiliziumschicht 3 ein Fenster, das genau unter der Maskenöffnung 7 der ursprünglichen Lackmaske 6 liegt und geringfügig größer ist als diese Maskenöffnung.

Zur Ätzung der Polysiliziumschicht 3 wird vorteilhaft ebenfalls ein selektives Verfahren verwendet, um die Dünnoxidschicht 2 nicht anzugreifen. Würde z.B. ein Ionenätzen verwendet, so könnte ebenfalls in der Polysiliziumschicht 3 das gewünschte Fenster erzeugt werden, jedoch würde auch die Dünnoxidschicht 2 angegriffen.

Soweit es erforderlich ist, kann auch die Dünnoxidschicht 2 noch weiter geätzt werden, wobei die Polysiliziumschicht 3 nunmehr als Maske dienen kann. Die abgesenkte Lackmaske 5 schützt dabei die Ätzkante der oben liegenden Dickoxidschicht 4.

Die Dickoxidschicht 4 kann z.B. auf einer Tiefe von 1,5 $\mu$m unter die ursprüngliche Lackmaske 6 unterätzt werden. Nach einer Polysiliziumätzung mit einer Unterätzung von z.B. 0,5 $\mu$m unter die durch das Aufheizen abgesenkte Lackmaske ergibt sich eine innerhalb geringer Toleranzen genau definierte Podestbreite d von weniger als 1 $\mu$m.

Im Vergleich zu dem Verfahren nach der Erfindung seien in: Fig. 2 die Verhältnisse dargestellt, die bei der üblichen Mehrfachschichten-Ätzung unter Benutzung selektiver Ätzmedien auftreten. Wird durch die Maskenöffnung der Fotolackmaske die Dickoxidschicht weggeätzt, so ist eine gewisse Unterätzung unvermeidlich, da zur minimalen Ätzzeit stets eine gewisse Sicherheitsreserve zugegeben werden muß, um die gesamte Schicht zuverlässig wegzuätzen. Die Ätzkante weist daher eine gewisse Böschung auf, die gegenüber der Lackkante zurückgesetzt ist. Wird nun die unter die Dickoxidschicht liegende Polysiliziumschicht selektiv weggeätzt, so wirkt nunmehr die Ätzkante des Dickoxids als Schutzmaske.

Bei diesem letzten Ätzvorgang entsteht eine gegenüber der Kante der Schutzmaske erneut zurückgesetzte Ätzkante, so daß eine Struktur erhalten wird, bei der die obenliegende Dickoxidschicht über die darunterliegende Polysiliziumschicht übersteht. Diese Struktur ist gerade entgegengesetzt zu der angestrebten Abstufung der übereinanderliegenden Schichten.

Selbstverständlich können auf diese Weise auch andere Stufenstrukturen hergestellt werden, bei denen z.B. eine Elektrodenschicht auf einem hervorspringenden Podest aus Isolationsmaterial ruht.

Die gemäß der Erfindung erzeugte Doppelstufe eignet sich besonders zur Herstellung eines sogenannten "doppeltimplantierten" MIS-Feldeffekt-Transistors, der eine Weiterentwicklung des "doppeltdiffundierten" MIS-Feldeffekt-Transistors ist.

Bei dem doppel-diffundierten MIS-FET wird, um eine hohe Schaltgeschwindigkeit zu erreichen, der Kanal dadurch besonders kurz gehalten, daß man zur Bildung des Source-Gebietes Dotierstoff eines ersten Leitungstyps durch eine Maskenöffnung in den Halbleiter-körper hineindiffundieren läßt. Anschließend wird in einem zweiten Dotierungsschritt Dotiermaterial des zweiten Leitungstyps durch die gleiche Maskenöffnung eindiffundiert, wobei durch die Wahl der Diffusionstemperatur und der Diffusionszeit dafür gesorgt wird, daß das Dotiermaterial in dem Halbleiterkörper durch Unterdiffusion seitlich über die Grenzen der Maskenöffnung hinaus diffundiert. Die seitliche Unterdiffusion wird beim zweiten Diffusionsschritt geringer gehalten als beim ersten Diffusionsschritt. Es entstehen dadurch zwei dotierte Gebiete, die an nebeneinanderliegenden Orten an der Substratoberfläche angrenzen. Der zwischen diesen Orten befindliche Teil des Halbleitersubstrates stellt den Kanal dar.

Bei dem doppelt implatierten MIS-FET kann die Dotierung mittels Ionenimplantation erzeugt werden, wodurch die Abmessungen der dotierten Gebiete wesentlich genauer bestimmt werden können. Ein derartiger MIS-FET ist in der nicht vorveröffentlichten deutschen Patentanmeldung P27 03 877.3 beschrieben. Zu seiner Herstellung wird als Maske für die Implantation der Ionen die Schicht des Gate-Oxids bzw. die Gate-Elektrode selbst benutzt, wobei diese Schichten mit keilförmigen Kanten hergestellt werden, d.h. die Dicke des Gate-Oxids bzw. der Gate-Elektrode nimmt von dem Source-Gebiet ausgehend kontinuierlich zu.

Das Verfahren gemäß der Erfindung erlaubt die Herstellung eines doppelt diffundierten MIS-FET mit besonders kurzer, genau definierbarer Kanallänge. Die Fig. 3 und 4 zeigen die Herstellung eines doppelt implantierten MIS-FET, bei dem die als Maske für die Doppelimplantation benutzte Dickenänderung der Gate-Oxidschicht bzw. der Gate-Elektroden-schicht nicht kontinuierlich verläuft, sondern eine Doppelstufe gemäß der Erfindung zeigt. Der Böschungswinkel an den Stufenkanten beträgt dabei nahezu 90°.

Auf dem Halbleiterkörper 1, z.B. aus p-dotiertem Silizium (Dotation z.B. $7 \cdot 10^{14}$ Atome/cm³) ist eine Isolierschicht 10, z.B. SiO$_2$ mit einer Dicke von 0,6 $\mu$m, aufgebracht und in dieser Schicht auf herkömmliche Weise ein Fenster freigelegt, das sich von der für das Source-Gebiet 11 vorgesehenen Fläche bis zu der für das Drain-Gebiet 12 vorgesehenen Fläche erstreckt. Durch Ionenimplantation oder Diffusion wird in diesem Fenster eine im gleichen Sinn wie das Drain-und Source-Gebiet dotiertes weiteres Gebiet 13 (Dotierung z.B. $10^{16}$ Arsen-Atome/$cm^3$) hergestellt.

Sodann wird über die ganze Oberfläche eine z.B. B. 0,006 μm dicke Dünnoxidschicht 2 gelegt, in der anschließend Fenster für den Anschluß der Source-Elektrode 15 und der Drain-Elektrode 16 geöffnet werden. Mittels Ionenimplantation oder Diffusion werden durch diese Fenster nun die Source- und Drain-Gebiete 11 bzw. 12 dotiert (z.B. Dotierung $10^{19}$ bis $10^{20}$ Arsen/$cm^3$). Anschließend wird die Oberfläche mit einer Schicht 3 aus Elektrodenmaterial und einer Dickoxidschicht 4 überdeckt. In diesen Schichten 3 und 4 werden nun gemäß der Erfindung unter Verwendung einer einzigen Lackmaske entsprechende Fenster geöffnet, wobei nach Entfernen der Lackmaske die in Fig. 3 gezeigte Struktur entsteht.

Durch Ionenimplantation (z.B. Arsen mit 150 keV Energie) können die direkt unter diesen Fenstern liegenden Verlängerungen 19 und 20 der Source- und Drain-Gebiete im gleichen Maße wie die Drain- und Source-Gebiete dotiert werden, so daß die Drain- bzw. Source-Dotierung sich nunmehr auch unter diese Fenster erstreckt. Die Schicht 3 aus Elektrodenmaterial und die Dickoxidschicht 4 werden nunmehr auch als Schutzmasken für eine zweite Dotierung verwendet, die einen zum Drain- bzw. Source-Gebiet entgegenesetzten Leitungstyp erzeugt. So kann z.B. Bor mit einer Beschleunigungsspannung von einigen Hundert keV und in einer Dosis von $1 \ldots 5.10^{12}/cm^2$ Ladungsträger verwendet werden. Die Ionen, die teilweise auch auf die Schichten 3 und 4 treffen, dringen unterschiedlich tief in den Halbleiterkörper ein und erzeugen somit ein entgegengesetzt zum Drain-Gebiet dotiertes Gebiet 21, dessen Verlauf etwa der Kontur der abgestuften Kanten der Schichten 3 und 4 entspricht. Das für die Drain-Elektrode vorgesehene Fenster der Schichten 3 und 4 wird dabei durch eine Fotolackschicht 18 abgedeckt. Schließlich wird die Fotolackschicht 18 entfernt und eine Temperung (Aktivierung) z.B. 10 Minuten bei 1000°C oder 30 Minuten bei 950°C, durchgeführt.

Es wird dadurch erreicht, daß unmittelbar neben der Verlängerung 19 des Source-Gebietes 11 ein entgegengesetzt dotiertes Gebiet 21 entsteht, das das Source-Gebiet in Richtung auf das Drain-Gebiet umschließt und neben dem Source-Gebiet an der Halbleiteroberfläche angrenzt. Das Kanalgebiet wird dabei von dem durch den äußersten Rand 22 des Drain-Gebietes und dem Rand des Gebietes 21 begrenzten Bereich gebildet, der Teil der sich vom Drain-Gebiet bis zum Source-Gebiet erstreckenden dotierten Schicht 13 ist. Die Länge L

dieses Kanalgebietes ist extrem klein und kann z.B. 0,1 μm betragen. Da Stufen der Schichten 3 und 4 nahezu senkrecht abfallen und die Stufenbreite d des vorspringenden Randes der Schicht 3 aus Elektrodenmaterial genau definiert ist, ist auch die Geometrie des Gebietes 21 und damit insbesondere die Kanallänge mit geringen Toleranzen genau definiert. Ein derartiger MIS-FET hat darüber hinaus den Vorteil, daß der Ausgangswiderstand infolge geringer Unabhängigkeit der effektiven Kanallänge von der Drain-Spannung extrem groß wird.

Wie schon erwähnt, entspricht das in Fig. 4 gezeigte Ausführungsbeispiel weitgehend einem MIS-FET, wie er in der deutschen Offenlegungsschrift 27 03 877 beschrieben ist, wobei dort jedoch anstelle einer Maske aus den abgestuften Schichten von Elektrodenmaterial 3 und Isolationsmaterial 4 eine Elektrodenschicht mit kontinuierlich sich verändernder Dicke beschrieben ist. Das Verfahren läßt sich daher auch auf die anderen in der genannten Patentanmeldung dargelegten Ausführungsbeispiele vorteilhaft anwenden.

**Patentansprüche**

1. Verfahren zur Erzeugung abgestufter Fenster in Materialschichten aus Isolations- (4) bzw. Elektrodenmaterial (3) für die Herstellung einer integrierten Halbleiterschaltung, wobei auf einem Halbleiterkörper oder auf einer auf ihm befindlichen Schicht (2) die Materialschichten übereinander aufgebracht und unter Verwendung von Lackmasken (5,6) soweit weggeätzt werden, daß die dem Halbleiterkörper benachbarte, untere Materialschicht (3) unter dem Rand der obenliegenden Materialschicht (4) hervorragt, gekennzeichnet durch die Verwendung einer einzigen Lackmaske, indem

a) nach dem Aufbringen der Materialschichten (3,4) die Lackmaske (6) auf die obenliegende Materialschicht (4) aufgetragen wird und die Maskenöffnungen der Lackmaske (6) derart gewählt werden, daß sie über den in die untere Materialschicht (3) zu ätzenden Fenstern liegen und etwas kleiner sind also diese Fenster,

b) anschließend die obere Materialschicht (4) durch die Maskenöffnung selektiv weggeätzt wird, wobei die Lackmaske (6) um eine vorgebbare Länge unterätzt wird,

c) die Lackmaske (6), gegebenenfalls nach vorangehendem Aufquellen, über den Fließpunkt aufgeheizt wird, bis sie sich auf die durch die Unterätzung freigelegten Teilflächen der unteren Materialschicht (3) auflegt, und

d) schließlich die von der abgesenkten Lackmaske (5) freigegebenen Flächen der unteren Materialschicht weggeätzt werden.

2. Verfahren nach Anspruch 1, dadurch gekennzeichnet, daß als Isoliermaterial $SiO_2$,

Al$_2$O$_3$ oder Si$_3$N$_4$ verwendet werden.

3. Verfahren nach einem der Ansprüche 1 oder 2, dadurch gekennzeichnet, daß als Elektrodenmaterial Polysilizium verwendet wird.

4. Verfahren nach einem der Ansprüche 1 bis 3, dadurch gekennzeichnet, daß zum selektiven Ätzen eine Plasma-Ätzung angewendet wird.

5. Verfahren nach einem der Ansprüche 1 bis 4, dadurch gekennzeichnet, daß die abgestuften Schichten als Maske für eine Ionen-implantation in den Halbleiterkörper verwendet werden.

6. Mit Hilfe des Verfahrens nach Anspruch 5 hergestellter MIS-Feldeffekt-Transistor mit kurzer Kanallänge, bestehend aus einem Halbleiterkörper (1), einem sich von der Halbleiteroberfläche in den Halbleiter erstreckenden, dotierten Source-Gebiet (11, 19) und einem in gleichem Sinn dotierten Drain-Gebiet (12) im Halbleiter, einem sich vom Rand des Source-Gebietes bis zum Drain-Gebiet erstreckenden, vorzugsweise schwächer im Sinn des Source-Gebietes dotierten Gebiet (13), einem weiteren, entgegengesetzt zum Source-Gebiet dotierten Gebiet (21), das seitlich neben dem Source-Gebiet (11, 19) an der Oberfläche angrenzt und das Source-Gebiet wenigstens in Richtung auf das Draingebiet umschließt, wobei das Kanalgebiet von dem Bereich zwischen dem äußeren Rand (22) des weiteren Gebietes und dem ihm benachbarten Rand des Source-Gebietes gebildet wird, einer das Kanalgebiet überdeckenden Isolierschicht (2) auf der Halbleiteroberfläche und einer darüberliegenden, nicht ganz bis zum Rand der Isolierschicht (2) reichenden Gate-Elektrode (3), dadurch gekennzeichnet, daß die abgestuften Materialschichten die Gate-Elektrode (3) und eine über ihr befindliche Isolationsschicht (4) sind und daß durch das von der die Gate-Elektrode bildenden Materialschicht und von der Isolationsschicht (4) geformte Fenster mit den abgestuften Kanten die Dotierung des Source-Gebietes (19) und des weiteren Gebietes (21) implantiert ist.

**Revendications**

1. Procédé pour fabriquer des fenêtres étagées dans des couches formées d'un matériau isolant (4) et d'un matériau pour électrodes (3) pour la fabrication d'un circuit intégré à semiconducteurs, selon lequel on dépose les couches de matériau de façon superposée sur un corps semiconducteur ou sur une couche (2) située sur ce dernier et, moyennant l'utilisation de masques de laque (5, 6), on élimine par attaque chimique lesdites couches jusqu'à ce que la couche inférieure de matériau (3), voisine du corps semiconducteur, fasse saillie au-dessous du corps de la couche supérieure de matériau (4), caractérisé par l'utilisation d'un seul masque de laque, avec la mise en œuvre des phases opératoires suivantes:

a) après le dépôt des couches de matériau (3, 4), on dépose le masque de laque (6) sur la couche supérieure de matériau (4) et on choisit les ouvertures du masque de laque (6) de telle manière qu'elles soient situées au'dessus des fenêtres devant être ménagées par attaque chimique dans la couche inférieure de matériau (3) et soient légèrement plus petites que ces fenêtres,

b) on élimine ensuite par attaque chimique sélective la couche supérieure de matériau (4) à travers l'ouverture du masque, le masque de laque (6) étant soumis à une attaque chimique sous-jacente sur une longueur pouvant être prédéterminée,

c) on chauffe le masque de laque (6), éventuellement après un gonflement préalable, au-dessus du point de fluage, jusqu'à ce qu'il se répande sur les surfaces partielles, mises à nu sous l'effet de l'attaque chimique sous-jacente, de la couche inférieure de matériau (3), et

d) enfin, on élimine par attaque chimique les surfaces, mises à nu par le masque de laque (5) abaissé, de la couche inférieure de matériau.

2. Procédé selon la revendication 1, caractérisé par le fait qu'on utilise comme matériau isolant du SiO$_2$, du Al$_2$O$_3$ ou du Si$_3$N$_4$.

3. Procédé selon l'une des revendications 1 ou 2, caractérisé par le fait qu'on utilise du polysilicium comme matériau pour les électrodes.

4. Procédé selon l'une des revendications 1 à 3, caractérisé par le fait qu'on utilise une attaque chimique plasmatique pour réaliser l'attaque chimique sélective.

5. Procédé selon l'une des revendications 1 à 4, caractérisé par le fait qu'on utilise les couches étagées comme masque pour une implantation d'ions dans le corps semiconducteur.

6. Transistor MIS à effet de champ à canal de courte longueur, fabriqué à l'aide du procédé selon la revendication 5 et constitué par un corps semiconducteur (1), par une région de source dopée (11, 19) s'étendant à partir de la surface du semiconducteur à l'intérieur de ce dernier et par une région de drain (12) possédant un dopage de même sens dans le semiconducteur, par une région (13) s'étendant depuis le bord de la région de source jusqu'à la région de drain et dopée de préférence plus faiblement avec le même type de dopage que la région de source, par une autre région (21) dopée avec un dopage opposé à celui de la région de source et qui jouxte la face supérieure, latéralement à côté de la région de source (11, 19) enserre la région de source au moins en direction de la région de drain, la région du canal étant formée par la région située entre le bord extérieur (22) de ladite autre région et le bord, qui en est voisin, de la région de source, et par une couche isolante (2) recouvrant la région du canal à la surface du semiconducteur et par une électrode de grille (3) située au-dessus et ne s'étendant pas complètement jusqu'au bord de la couche isolante (2), caractérisé par le fait que les couches étagées de matériau sont l'électrode de grille (3) et une couche isolante (4) située au-dessus de cette dernière et que le dopage de la région de source (19) et de ladite autre région (21) est implantée à travers la fenêtre, formée par la couche de matériau constituant l'électrode de grille et par la couche isolante (4) et comportant les bords étagés.

## Claims

1. Process for the production of stepped windows in layers consisting of insulating material (4) and electrode material (3) in the formation of an integrated semiconductor circuit, in which said layers are applied one above another on a semiconductor body or on a layer (2) arranged thereon, and are etched away with the aid of lacquer masks (5, 6) to such an extent that the lower layer (3) which is adjacent to the semiconductor body projects beyond the edge of the layer (4) which is arranged on top, characterised in that a single lacquer mask is used, and in that:—

a) after the application of the layers (3, 4), the lacquer mask (6) is applied to the layer (4) which is arranged on the top, and the mask openings of the lacquer mask (6) are so selected that they lie above the windows which are to be etched into the lower layer (3), and are somewhat smaller than these windows;

b) subsequently, the upper layer (4) is selectively etched away through the mask opening, whereby the lacquer mask (6) is underetched by a predetermined length;

c) the lacquer mask (6), possibly after previous swelling, is heated above the flow point until it is deposited on the parts of the surface of the lower layer (3) exposed by the underetching; and

d) finally, the surfaces of the lower layer which are exposed by the lowered lacquer mask (5) are etched away.

2. Process as claimed in Claim 1, characterised in that $SiO_2$, $Al_2O_3$ or $Si_3N_4$ is used as insulating material.

3. Process as claimed in one of Claims 1 or 2, characterised in that polysilicon is used as electrode material.

4. Process as claimed in any one of Claims 1 to 3, characterised in that a plasma-etching is used for the selective etching.

5. Process as claimed in any one of Claims 1 to 4, characterised in that the stepped layers are used as a mask for an ion implantation into the semiconductor body.

6. MIS-field effect transistor having a short channel length which is produced by means of the process as claimed in Claim 5, and which consists of a semi-conductor body (1); a doped source zone (11, 19) which extends from the semiconductor surface into the semiconductor;. a drain zone (12) in the semiconductor which is doped in the same sense; a zone (13) which is doped in the same sense as the source zone (preferably more weakly) and extends from the edge of the source zone to the drain zone; a further zone (21) which is oppositely doped to the source zone, laterally borders on the source zone (11, 19) at the surface and encloses the source zone at least in the direction towards the drain zone, whereby the channel zone is formed by the region between the outer edge (22) of the further zone and the edge of the source zone which is adjacent thereto; an insulating layer (2) on the semiconductor surface covering the channel zone; and a gate electrode (3) lying thereon which does not quite extend to the edge of the insulating layer (2), characterised in that the stepped layers constitute the gate electrode (3) and an insulation layer (4) which is arranged above the latter, and that the doping for the source zone (19) and the further zone (21) is implanted through the window which has the stepped edges and which is formed by the layer which constitutes the gate electrode and by the insulation layer (4).

Fig.1

Fig.2

Fig.3

Fig.4